# EUROPEAN PATENT APPLICATION

(11) **EP 1 571 718 A1**
(43) Date of publication of application: **07.09.2005**
(21) Application number: 04075683.5
(22) Date of filing: 04.03.2004
(51) Int. Cl.: H01L 35/30, H01L 35/00

(54) **Portable apparatus for generating electrical energy with a thermoelectric element**

(71) Applicant: Van den Brandhof, Evert Alexander, 2311 PJ Leiden (NL)
(72) Inventor: van den Brandhof, Evert Alexander, 2311 PJ Leiden (NL); Loaiza, Mauricio, 2274 GC Voorburg (NL)
(74) Representative: Eveleens Maarse, Pieter

(57) **Abstract**

The invention relates to a portable apparatus for generating electric energy, comprising
- at least one thermoelectric element with a first side and a second side;
- a burner for heating the first side of the at least one thermoelectric element; and
- cooling means for maintaining the ambient temperature at the second side of the at least one thermoelectric element.

Instead of using the prior art direct conversion of chemical energy into electrical energy as used by a battery, the present invention uses the conversion of chemical energy into electrical energy with the intermediate step of the conversion into heat through combustion and subsequently the conversion of heat into electrical energy by means of a thermoelectric element.

This has the advantage that chemical energy can be used as a fuel, of which the density of energy per volume or weight is much higher than that of a battery.

## Description

The invention relates to a portable apparatus for generating electric energy.

These apparatuses are generally known in the shape of batteries. In those batteries chemical energy is converted into electrical energy.

These batteries are quite often used to supply electric power to laptop computers in situations wherein electricity from the main network is unavailable.

A severe problem with these batteries is the fact that they exhaust relatively quick.

The aim of the invention is to provide a portable apparatus for electric energy of which the energy content is higher, so that its use extends over a longer period.

Such an apparatus could then be used to recharge a battery.

This aim is reached through a portable apparatus for generating electric energy which comprises at least one thermoelectric element with a first side and a second side, a burner for heating the first side of the at least one thermal electric element and cooling means for maintaining the ambient temperature a the second side of the thermoelectric element.

Instead of using the prior art direct conversion of chemical energy into electrical energy as used by a battery, the present invention uses the conversion of chemical energy into electrical energy with the intermediate step of the conversion into heat through combustion and subsequently the conversion of heat into electrical energy by means of a thermoelectric element.

This has the advantage that chemical energy can be used as a fuel, of which the density of energy per volume or weight is much higher than that of a battery.

Thus, a certain amount of energy can be taken along with a substantially smaller volume.

According to a first preferred embodiment the burner is adapted to combust gaseous fuels, and the burner is adapted to be connected with a container for gaseous fuels.

This feature offers the option of using gaseous fuels which are readily available in small containers, like those which are used for camping purposes, for soldering, hair curlers etcetera.

A more preferred embodiment provides the feature that the apparatus comprises coupling means which are adapted to be coupled with a fire lighter.

A fire lighter comprises a small amount of gaseous fuel, often compressed to such an amount that it only has a small volume.

Fire lighters are easily available and they usually contain enough fuel to have the apparatus according to the invention work for about twenty minutes.

Another preferred embodiment provides the feature that the coupling means are adapted to form a rigid connection between the fire lighter and the apparatus.

This improves the safety of the connection and thus the safety of the apparatus.

Fire lighters are provided with a valve which opens during ignition to allow the fuel from the container to enter its burner. In the case of the present invention a separate burner is used, so that the burner of the fire lighter is not active. Nevertheless, the valve must be opened to allow the fuel to enter the apparatus according to the invention. Thus, it is attractive that the coupling means are adapted to open the valve of the fire lighter.

One of the makes of fire lighter, which is widely available around the world, are the fire lighters of the make BIC®. It is thus attractive to adapt the coupling means to fire lighters of this make.

Another preferred embodiment provides the feature that the apparatus comprises an igniter for igniting the burner when it is switched on.

Thermoelectric elements function when a temperature difference is applied over their sides. This implies that when one of the sides of the thermoelectric element is heated, the other one should be maintained at a temperature substantially below that of the heated side.

This can be provided for by cooling means which comprise heat sinks.

The effect of the heat sinks can be improved when they are coupled with at least one hollow space in which a heat capacitor is located.

The heat capacitor can take several shapes and it appears to be very attractive when it comprises a material which undergoes a change of phase during its change of temperature. Test have indicated that it is very attractive, when the material is chosen such that its change of phase takes place at a temperature of about 50°.

Research has led to the conclusion that the material Ni(NO₃)₂**·**6H₂O is a very attractive material for the heat capacitor.

To improve the portability of the apparatus it is attractive to use a substantially radial configuration.

It is then attractive when the burner is located in the centre of the apparatus, the thermoelectric elements are arranged around the upper part of the burner, and that the second side of the thermoelectric elements are surrounded by the cooling means.

The electric energy generated by a thermoelectric element is delivered through a voltage which is dependant on several variables. Nearly every apparatus to be supplied with electrical energy needs a supply voltage of a predetermined value.

To be able to supply electrical energy with a predetermined voltage it is attractive when the thermoelectric elements are electrically coupled with a converter. It is expected that it is very attractive to use the apparatus according to the present invention to recharge the batteries of a laptop computer or to supply a laptop computer itself.

A preferred embodiment provides the feature that the electric converter is adapted to supply a voltage adapted to charge the battery of a laptop computer or to supply the laptop computer.

Subsequently, the present invention will be elucidated with the help of the accompanying drawings, in which:
figure 1 shows a perspective view of a preferred embodiment of the present invention;

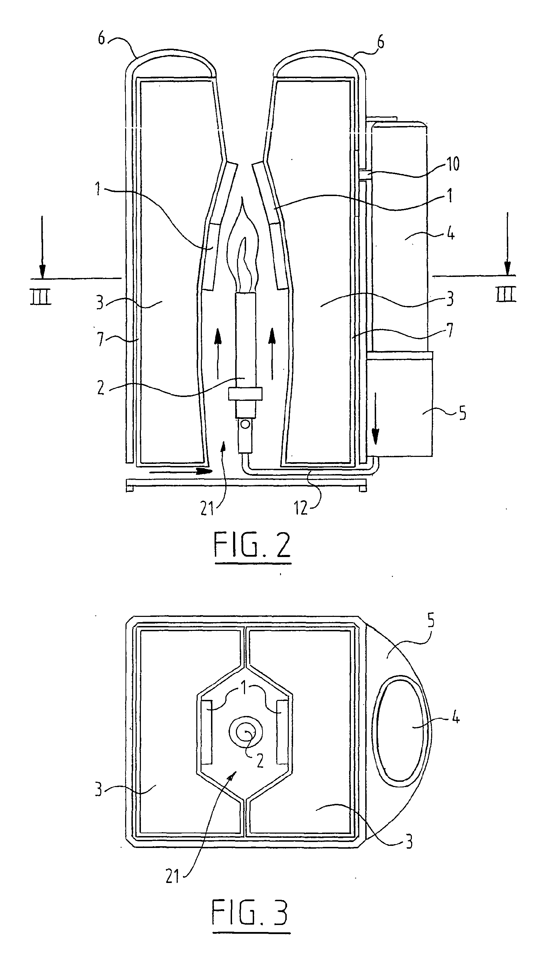

figure 2 shows a cross-section of the embodiment depicted in figure 1;
figure 3 shows a horizontal cross-section according to the lines A-A in figure 2; and

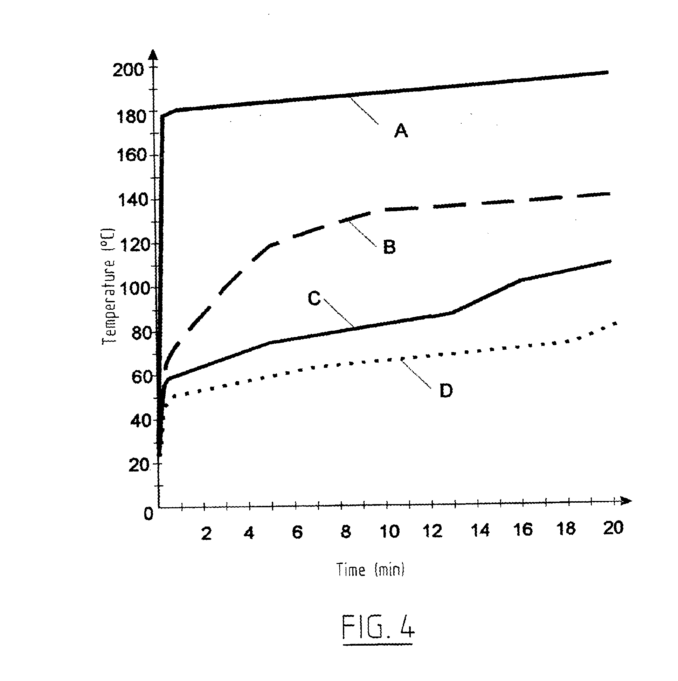

figure 4 shows a diagram showing the relation between temperature and time on four different locations in the apparatus according to the invention.

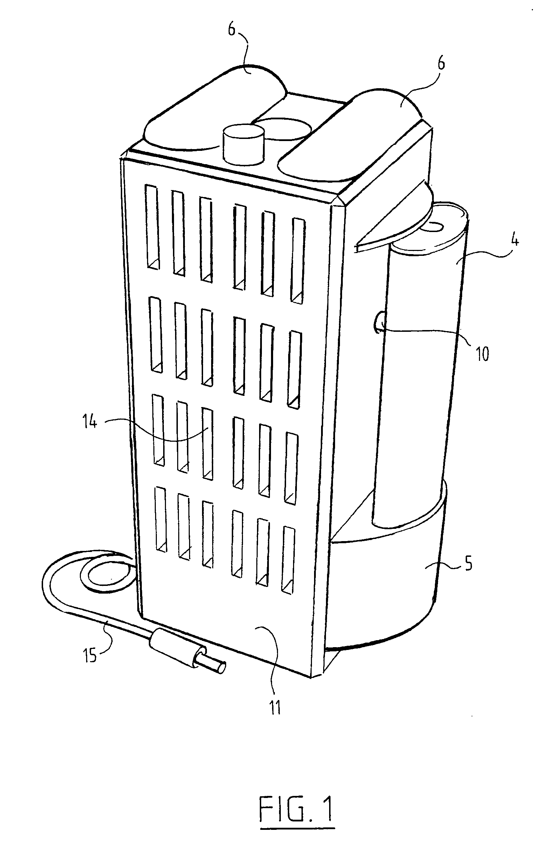

The portable apparatus according to the invention is depicted in figure 1. It comprises a housing 11 in which ventilation apertures 14 have been provided. Within the housing is a Bunsen-burner which is centrally located in the housing. The Bunsen-burner is within a vertical channel 16 and at the upper end of the Bunsen-burner 2 it is surrounded by a number of thermoelectric elements 1. The thermoelectric elements are surrounded by cooling elements 3, which are also located within the housing 11. The ventilation apertures 14 serve to obtain a cooling air flow alongside the cooling element 3.

To provide the Bunsen-burner 2 with fuel a lighter receiver 5 has been provided which is connected to the housing 11. From the lighter receiver a gas channel 12 extends to the underside of the Bunsen-burner. A fire lighter, in particular a BIC® fire lighter 4, can be located upside down with its burner head into the lighter receiver 5. The lighter receiver 5 is adapted to open its valve when the lighter 4 is located with its head into the lighter receiver 5. A flow of gas from the gas reservoir of the lighter towards the Bunsen-burner is then obtained.

Further, the apparatus comprises an ignition device needed to ignite the flame of the burner. Only the control knob 13 thereof is shown in figure 1.

The lower side of the housing 11 also comprises two larger apertures through which air is supplied to the channel in which the burner is located. These apertures provide a supply of air.

Surrounding the vertical channel 21 cooling elements 3 have been provided. Each of these cooling elements 3 comprise a housing 7 which can be made of aluminium, and which as such functions as a heat sink.

Within the housing of the cooling elements a material is present, which has a relatively large heat capacity, so that the heating thereof takes place only slowly. This feature is needed to keep the second side of the thermoelectric element at the ambient temperature as long as possible.

To further improve this effect the material is chosen such, that its melting point is within the path of the temperature which is travelled through from the ignition of the Bunsen-burner until the end of the heating cycle. The end of the heating cycle is reached at a temperature leading to a temperature difference over the thermoelectric element at which it still delivers some electrical energy.

A suitable material is Ni(NO₃)₂·6H₂O.

As a safety precaution the apparatus is provided with a bimetal spring, which acts at the predetermined temperature. The bimetal spring has an general annular shape with an extension pointing inward. On this extension a pin perpendicular to the plane of the spring has been provided. The bimetal spring is arranged such that when the temperature raises above a predetermined temperature, its shape changes suddenly from flat to bulged so that its pin pushes the fire lighter 4 from the position wherein it is connected with lighter receiver 5. When the fire lighter 4 is pushed away from its normal positon in which it keeps its valve open, the valve will close so that the gas flow is cut off. It is however possible to use other shapes of bi-metal springs.

A good thermal coupling between the cooling means and the bimetal spring is essential for a proper protection.

The thermoelectric elements 1 are all connected with two wires and they are connected in parallel.

Of course it is also possible to connect them in series; this is dependent on the kind of element chosen and of the voltage which the apparatuses are supposed to generate. These bear, of course, a relation with a possible electrical converter which is not depicted in the drawings and which is necessary to convert the voltage generated by the thermoelectric elements to the voltage required for supplying to the batteries.

Subsequently, the working of this apparatus will be described.

Initially, a fire lighter, preferably of the make BIC®, is inserted upside down into the lighter receiver 5. The shape of the lighter receiver 5 is such that the valve present in the lighter will open, so that the gas emerging from the fire lighter is fed towards the gas channel 12.

Subsequently, the ignition system is activated by pressing the knob 13. This leads to ignition of the Bunsen-burner 2 and the forming of a flame at the top thereof. This flame heats the inner side of the thermoelectric elements 1, which, at their outer sides, are cooled by the cooling elements 3. As a consequence thereof, the thermoelectric elements start to generate an electrical voltage which is possibly converted in an electrical converter and subsequently fed towards a connecting cable 15, suitable for connecting to a laptop computer.

The process of burning is continued for about twenty minutes. After twenty minutes the cooling elements have warmed up so far, that the temperature gradient over the thermoelectric elements is so small, that not sufficient electric power is generated. Generally the fuel in the lighter is not exhausted yet after 20 minutes. However the thermal capacity of the cooling element can be increased at the cost of a higher weight.

Herein it is noted that the raise of the temperature of the cooling elements is limited by the relatively high thermal coefficient of the matter present in those cooling elements and secondly by the change of phase, in particular the melting of this material.

## Claims

1. Portable apparatus for generating electric energy,
**characterized by:**
- at least one thermoelectric element with a first side and a second side;
- a burner for heating the first side of the at least one thermoelectric element; and
- cooling means for maintaining the ambient temperature at the second side of the at least one thermoelectric element.

2. Apparatus as claimed in claim 1, **characterized in that** the burner is adapted to combust gaseous fuel and that the burner is adapted to be connected with a container for gaseous fuel.

3. Apparatus as claimed in claim 2, **characterized in that** the apparatus comprises coupling means which are adapted to be coupled with a fire lighter.

4. Apparatus as claimed in claim 3, **characterized in that** the coupling means are adapted to form a rigid connection between the fire lighter and the apparatus.

5. Apparatus as claimed in claim 4, **characterized in that** the coupling means are adapted to open a valve of the fire lighter.

6. Apparatus as claimed in claim 3, 4 or 5, **characterized in that** the coupling means are adapted to be connected to a fire lighter of the make 'BIC'®.

7. Apparatus as claimed in any of the preceding claims, **characterized by** an ignitor for igniting the burner.

8. Apparatus as claimed in any of the preceding claims, **characterized in that** the cooling means comprise heat sinks.

9. Apparatus as claimed in claim 8, **characterized in that** the heat sinks are coupled with at least one hollow space in which a heat capacitor is located.

10. Apparatus as claimed in claim 9, **characterized in that** the heat capacitor comprises a material which undergoes a change of phase during its change of temperature.

11. Apparatus as claimed in claim 10, **characterized in that** the housing of the hollow space comprises at least one flexible wall part.

12. Apparatus as claimed in claim 10 or 11, **characterized in that** the material is Ni(NO₃)₂**·**6H₂O.

13. Apparatus as claimed in any of the preceding claims, **characterized in that** the burner is located in the centre of the apparatus, that the thermoelectric elements are arranged around the upper part of the burner and that at the second sides of the thermoelectric elements are surrounded by the cooling means.

14. Apparatus as claimed in any of the preceding claims, **characterized by** a control unit to switch of the gas supply when the temperature of the burner raises above a predetermined threshold level.

15. Apparatus as claimed in claim 14, **characterized in that** the control unit comprises a bi-metal switch thermally coupled to the cooling element.

16. Apparatus as claimed in claim 15, **characterized in that** the bi-metal spring is adapted to push the container away from its position in which it connected with the coupling means.

17. Apparatus as claiemd in claim 16, **characterized in that** the bimetal spring is arranged to change its state sharply when the predetermined temparature is reached.

18. Apparatus as claimed in one of the preceding claims, **characterized in that** the thermoelectric elements are electrically coupled with an electric converter.

19. Apparatus as claimed in claim 16, **characterized in that** the electric converter is adapted to supply a voltage adapted to charge the battery of a laptop computer.

20. Apparatus as claimed in any of the preceding claims, **characterized in that** the electric converter is adapted to charge the battery of a mobile telephone.
